# EUROPEAN PATENT APPLICATION

(11) **EP 4 780 158 A2**
(43) Date of publication of application: **22.07.2026**
(21) Application number: 25221168.5
(22) Date of filing: 05.12.2025
(51) Int. Cl.: H10B 12/00, H10D 1/68

(54) **SEMICONDUCTOR DEVICE WITH STORAGE NODE AND METHOD OF FABRICATING THE SAME**

(30) Priority: 31.12.2024 KR 20240202641
(71) Applicant: SK hynix Inc., Bubal-eub Icheon-si Gyeonggi-do 17336 (KR)
(72) Inventor: LEE, Dong Ryeol, 17336 Icheon-si, Gyeonggi-do (KR)
(74) Representative: Isarpatent

(57) **Abstract**

A semiconductor device including a storage node and a method of fabricating the same is provided. In the method of fabricating the semiconductor device, an insulation layer is formed over a substrate, and a first hole and a second hole that penetrate the insulation layer are formed. A recess is formed in the insulation layer to overlap the first hole. A first conductive pattern that fills the first hole and the recess and a second conductive pattern that fills the second hole are formed. A third conductive pattern connected to the second conductive pattern is formed.

## Description

### BACKGROUND

### 1. Technical Field

The present disclosure generally relates to an integrated circuit device and, more particularly, to a semiconductor device with a storage node and a method of fabricating the same.

### 2. Related Art

As semiconductor devices become more highly integrated, circuit patterns that make up the semiconductor devices are becoming increasingly smaller. Concurrently, research is being directed at increasing the capacitance of capacitors among circuit elements that make up the semiconductor devices.

### SUMMARY

Embodiments of the present disclosure provide a semiconductor device that includes a storage node of a capacitor and a method of fabricating the same.

According to an embodiment, a method of fabricating a semiconductor device may include forming an insulation layer over a substrate, forming a first hole and a second hole that penetrate the insulation layer, forming a recess in the insulation layer that overlaps the first hole, forming a first conductive pattern that fills the first hole and the recess and a second conductive pattern that fills the second hole, and forming a third conductive pattern connected to the second conductive pattern.

According to another embodiment, a method of fabricating a semiconductor device may include forming an insulation layer over a substrate, forming a first hole, a trench, and a second hole to penetrate the insulation layer, the trench dividing the insulation layer into a first portion and a second portion, forming a first conductive pattern that fills the first hole, a fifth conductive pattern that fills the trench and a second conductive pattern that fills the second hole, forming a third conductive pattern connected to the second conductive pattern, and removing the second portion of the insulation layer to expose a first side surface of the second conductive pattern.

According to another embodiment, a semiconductor device may include an insulation layer disposed over a first region of a substrate. The substrate may include the first region and a second region. The semiconductor device may include a first conductive pattern that penetrates the insulation layer, a second conductive pattern formed over the second region, a third conductive pattern connected to the second conductive pattern, and a binding layer covering the first conductive pattern and the insulation layer and connected to the third conductive pattern.

### BRIEF DESCRIPTION OF THE DRAWINGS

FIG. 1 is a schematic cross-sectional view illustrating a structure in which a protection layer of a semiconductor device is formed according to an embodiment of the present disclosure.
FIG. 2 is a schematic cross-sectional view illustrating a structure in which an insulation layer is formed on a protection layer of a semiconductor device according to an embodiment of the present disclosure.
FIG. 3 and FIG 4 are schematic cross-sectional view and plan view, respectively, illustrating a structure in which holes and a trench are formed in an insulation layer of a semiconductor device according to an embodiment of the present disclosure.
FIG. 5 and FIG 6 are schematic cross-sectional view and plan view, respectively, illustrating a structure in which recesses are formed in an insulation layer of a semiconductor device according to an embodiment of the present disclosure.
FIG. 7 is a schematic cross-sectional view illustrating a structure in which a conductive layer is formed in an insulation layer of a semiconductor device according to an embodiment of the present disclosure.
FIG. 8 is a schematic cross-sectional view illustrating a structure in which conductive patterns of a semiconductor device are separated according to an embodiment of the present disclosure.
FIG. 9 is a schematic cross-sectional view illustrating a structure in which a binding layer of a semiconductor device is formed according to an embodiment of the present disclosure.
FIG. 10 is a schematic cross-sectional view illustrating a structure in which openings are formed in a binding layer of a semiconductor device according to an embodiment of the present disclosure.
FIG. 11 is a schematic cross-sectional view illustrating a structure in which a mold layer of a semiconductor device is formed according to an embodiment of the present disclosure.
FIG. 12 is a schematic cross-sectional view illustrating a structure in which holes are formed in a mold layer of a semiconductor device according to an embodiment of the present disclosure.
FIG. 13 is a schematic cross-sectional view illustrating a structure in which a conductive pattern is formed in a mold layer of a semiconductor device according to an embodiment of the present disclosure.
FIG. 14 is a schematic cross-sectional view illustrating a structure in which an opening is formed in another binding layer of a semiconductor device according to an embodiment of the present disclosure.
FIG. 15 is a schematic cross-sectional view illustrating a structure in which a portion of a mold layer of a semiconductor device according to an embodiment of the present disclosure.
FIG. 16 is a schematic cross-sectional view illustrating a structure in which an opening is formed in another binding layer of a semiconductor device according to an embodiment of the present disclosure.
FIG. 17 is a schematic cross-sectional view illustrating a structure in which a mold layer of a semiconductor device is removed according to an embodiment of the present disclosure.
FIG. 18 is a schematic cross-sectional view illustrating a structure in which a portion of an insulation layer of a semiconductor device according to an embodiment of the present disclosure is removed.
FIG. 19 is a schematic cross-sectional view illustrating a structure in which a capacitor dielectric layer of a semiconductor device is formed according to an embodiment of the present disclosure.
FIG. 20 is a schematic cross-sectional view illustrating a structure in which another conductive pattern of a semiconductor device is formed according to an embodiment of the present disclosure.

### DETAILED DESCRIPTION

Hereinafter, embodiments of the present disclosure will be described in detail with reference to the accompanying drawings. In the drawings, in order to clearly express the components of each device, the sizes of the components, such as width and thickness of the components, may be enlarged. The cross-hatching throughout the figures illustrates corresponding or similar areas between the figures rather than indicating the materials associated with the areas.

The terms used herein may correspond to words selected in consideration of their functions in the embodiments, and the meanings of the terms may be construed to be different according to the ordinary skill in the art to which the embodiments belong. If expressly defined in detail, the terms may be construed according to the definitions. Unless otherwise defined, the terms (including technical and scientific terms) used herein have the same meaning as commonly understood by one of ordinary skill in the art to which the embodiments belong.

In the description of the present disclosure, terms such as "first," "second," etc. are used to distinguish components, and are not used to limit the components themselves or to imply a specific order. In the description of the present disclosure, terms such as "top surface," "bottom surface," "side," etc. do not limit a specific direction, location, or component. Terms such as "below," "beneath," "lower," "above," "over", and "upper" can be used to describe the spatial relative positions between components.

Embodiments of the present disclosure can be applied to a technical field of implementing integrated circuit devices such as Dynamic Random Access Memory (DRAM), Phase-change random access memory (PcRAM), or Resistive Random-Access Memory (ReRAM) devices. In addition, embodiments of the present disclosure can be applied to a technical field of implementing a memory device that stores data or a logic device that performs logical operations. Embodiments of the present disclosure can be applied to a technical field of implementing various products that include fine-sized conductive patterns.

Terms used in the specification of the present application are terms selected in consideration of functions in the presented embodiments, and the meaning of the terms may vary depending on the intention or custom of a user or operator in the technical field. The meanings of the terms used follow the definitions defined when specifically defined herein, and may be interpreted as meanings generally recognized by those skilled in the art in the absence of specific definitions.

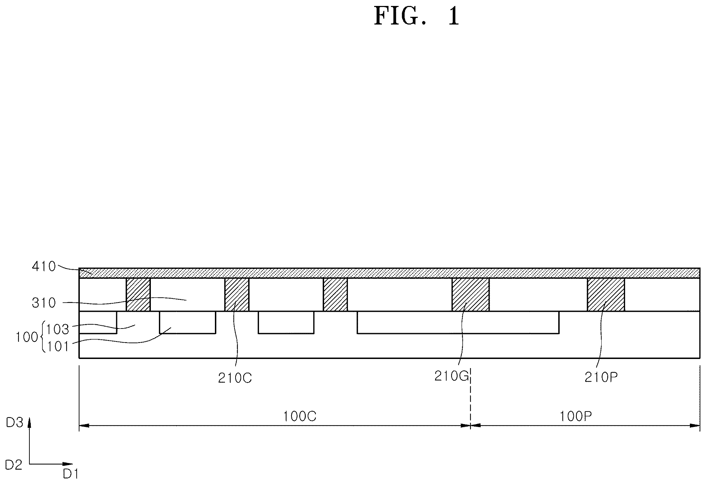

FIG. 1 to FIG. 20 are schematic views illustrating semiconductor devices and methods of fabricating semiconductor devices according to embodiments of the present disclosure.

FIG. 1 illustrates a schematic cross-sectional structure in which a protection layer 410 is formed over a substrate 100. The substrate 100 includes a surface extending in a first direction D1 and a second direction D2. The protection layer 410 is formed while being spaced apart from the surface of the substrate 100 in a third direction D3. The first direction D1 intersects the second direction D2, and the third direction D3 is perpendicular to the first direction D1 and the second direction D2. The first direction D1, the second direction D2, and the third direction D3 may indicate the X-axis, Y-axis, and Z-axis in the X-Y-Z coordinate system, respectively, in this example, and the present disclosure is not limited to this example.

The substrate 100 includes a semiconductor material such as silicon (Si). Integrated circuits such as transistors may be integrated on the substrate 100. The substrate 100 may include silicon germanium (SiGe). The substrate 100 may include a compound semiconductor material such as silicon carbide (SiC), gallium arsenide (GaAs), indium arsenide (InAs), or indium phosphorus (InP).

The substrate 100 includes an isolation layer 103 that defines active regions 101. The active regions 101 are doped with impurities. The active regions 101 may be used as source regions, drain regions, or channels of transistors. The isolation layer 103 includes a field oxide layer. The isolation layer 103 includes silicon oxide including silicon dioxide (SiO₂) or silicon nitride such as trisilicon tetranitride (Si₃N₄).

The substrate 100 includes a first region 100P and a second region 100C. The first region 100P of the substrate 100 may be a peripheral region, and the second region 100C of the substrate 100 may be a cell region. The first region 100P of the substrate 100 is a region surrounding the second region 100C. Memory cells are disposed in the second region 100C of the substrate 100, and peripheral circuits are disposed in the first region 100P of the substrate 100. The memory cells include elements that store data, such as transistors and/or capacitors. The peripheral circuits include circuits that control the operations of the memory cells, such as a sense amplifier (SA) or a sub-word line driver (SWD).

Various substructures may be formed between the substrate 100 and the protection layer 410. The substructures may include various insulation layers and conductive layers. In an embodiment, a first insulation layer 310 is formed on the substrate 100, and a first contact 210P, second contacts 210C, and a third contact 210G are disposed that substantially penetrate the first insulation layer 310. The first contact 210P and the second contact 210C are connection elements electrically connected to the active regions 101 of the substrate 100. The connection elements may be conductive plugs or conductive vias. The first contact 210P is disposed on the first region 100P of the substrate, and the second contacts 210C are disposed on the second region 100C of the substrate. The third contact 210G is disposed at a boundary between the first region 100P of the substrate and the second region 100C of the substrate. The third contact 210G is formed of a conductive material, but may be a dummy pattern connected to the device isolation layer 103 of the substrate 100.

Each of the first contact 210P, the second contact 210C, and the third contact 210G includes a conductive material. Each of the first contact 210P, the second contact 210C, and the third contact 210G includes tungsten (W), titanium nitride (TiN), tungsten nitride (WN), titanium tungsten nitride (TiWN), tungsten silicon nitride (WSiN), or a composite layer thereof. Each of the first contact 210P, the second contact 210C, and the third contact 210G also includes a polycrystalline silicon layer doped with impurities. The first insulation layer 310 includes a dielectric material such as silicon oxide.

The protection layer 410 covers (and may be disposed in a manner to protect or shield) an underlaying substructure including the first insulation layer 310, the first contact 210P, the second contacts 210C, and the third contact 210G. The protection layer 410 may include a different dielectric material from the first insulation layer 310. In an embodiment, the protection layer 310 includes silicon nitride.

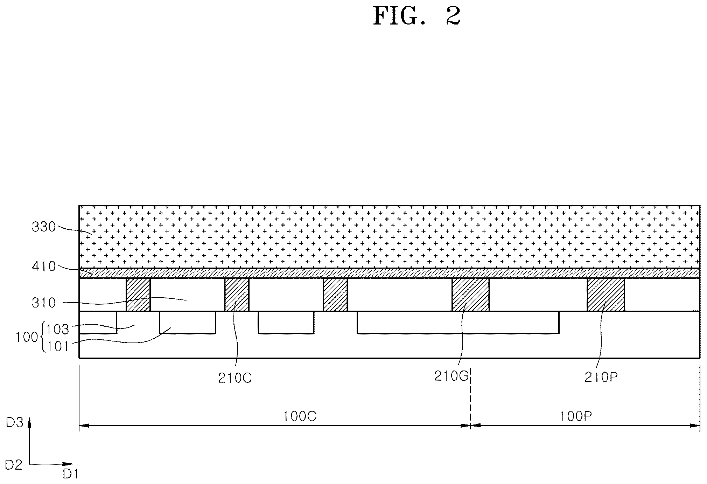

FIG. 2 illustrates a schematic cross-sectional structure in which a second insulation layer 330 is formed on the protection layer 410. The second insulation layer 330, including a different insulating material or a different dielectric material from the protection layer 410, is formed on the protection layer 410. The second insulation layer 330 may include a different dielectric material from the protection layer 410. In an embodiment, the second insulation layer 330 includes silicon oxide.

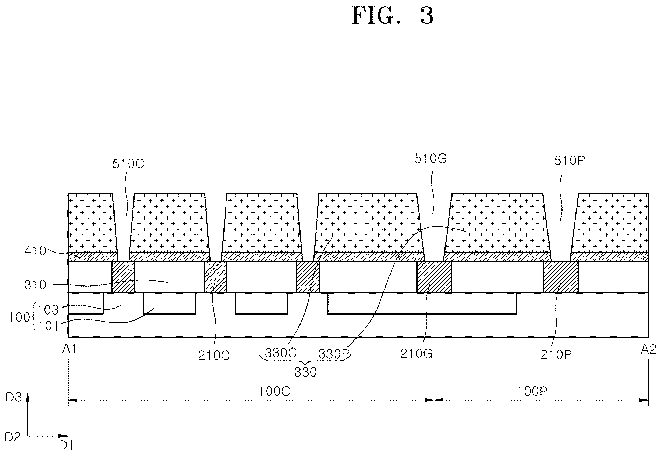

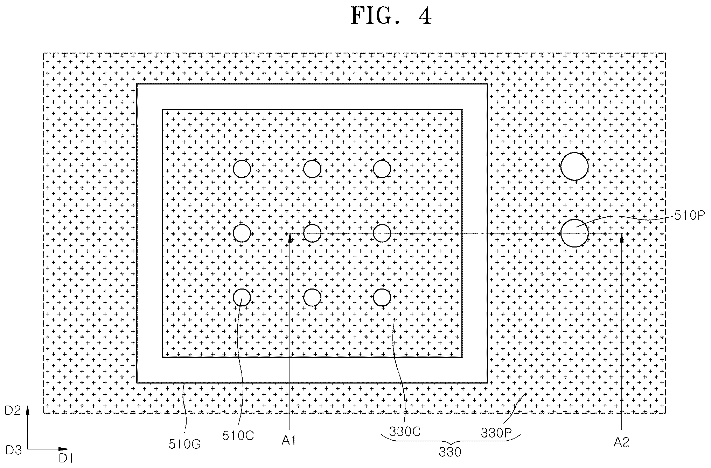

FIG. 3 illustrates a schematic cross-sectional structure in which first holes 510P, a trench 510G, and second holes 510C are formed in the second insulation layer 330. FIG. 4 illustrates a schematic planar structure in which the first holes 510P, the trench 510G, and the second holes 510C are formed in the second insulation layer 330. FIG. 3 illustrates a cross-sectional shape taken along line A1-A2 in FIG. 4. Some portions of the second insulation layer 330 may be removed to form the first holes 510P, the trench 510G, and the second holes 510C. The first holes 510P, the trench 510G, and the second holes 510C substantially penetrate the second insulation layer 330 in the third direction D3.

A plurality of first holes 510P are disposed over the first region 100P of the substrate 100. A plurality of second holes 510C are arranged over the second region 100C of the substrate 100. The trench 510G is formed at a boundary between the first region 100P and the second region 100C of the substrate 100. The trench 510G extends along the boundary between the first region 100P and the second region 100C of the substrate 100. The trench 510G is formed in a line shape that extends long in one direction. The trench 510G extends to surround the second holes 510C or surround an array of the second holes 510C. The trench 510G is formed in a closed form, such as a ring shape, a rectangular shape, or a loop shape.

The trench 510G divides the second insulation layer 330 into a first portion 330P and a second portion 330C. The first portion 330P of the second insulation layer 330 overlaps with the first region 100P of the substrate 100, and the second portion 330C of the second insulation layer 330 overlaps with the second region 100C of the substrate 100. The first holes 510P extend along the third direction D3 to substantially penetrate the first portion 330P of the second insulation layer 330. The second holes 510C extend along the third direction D3 to substantially penetrate the second portion 330C of the second insulation layer 330. The first holes 510P, the trench 510G, and the second holes 510C further extend along the third direction D3 to substantially penetrate the protection layer 410 under the second insulation layer 330. The first holes 510P are formed to expose some portions of the underlying first contacts 210P. The trench 510G is formed to expose a portion of the underlying third contact 210G. The second holes 510C are formed to expose some portions of the underlying second contacts 210C.

The first holes 510P, the trench 510G, and the second holes 510C may be formed simultaneously. The first holes 510P, the trench 510G, and the second holes 510C may be formed in one and the same first patterning process. In an embodiment, a first etch mask (not shown) is formed on the second insulation layer 330 using a first photolithography process, and some portions of the second insulation layer 330 exposed by the first etch mask are etched to form the first holes 510P, the trench 510G, and the second holes 510C. The first etch mask may include a first photoresist pattern or may further include a first hard mask having a pattern shape substantially the same as that of the first photoresist pattern.

The first photoresist pattern implemented on the second insulation layer 330 by the first photolithography process has a planar pattern shape that is substantially the same as the planar pattern shape on a surface of the second insulation layer 330 shown in FIG. 4. Because the first holes 510P, the trench 510G, and the second holes 510C may have different sizes, widths, or shapes, the first photoresist pattern for implementing the first holes 510P, the trench 510G, and the second holes 510C may be formed using a high numerical aperture extreme ultraviolet lithography tool.

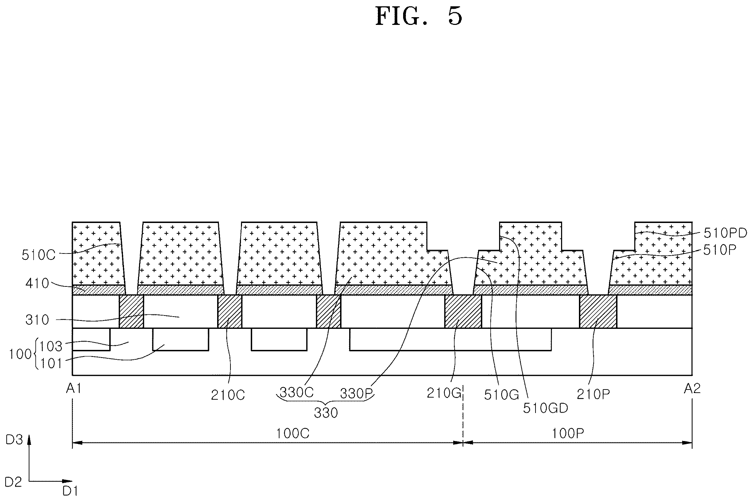

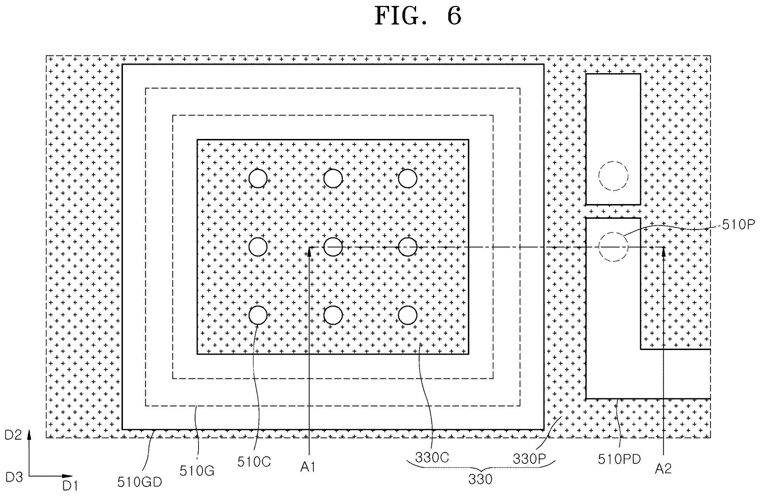

FIG. 5 illustrates a schematic cross-sectional structure in which recesses 510PD and 510GD are formed in the second insulation layer 330. FIG. 6 illustrates a schematic planar structure in which the recesses 510PD and 510GD are formed in the second insulation layer 330. FIG. 5 illustrates a cross-sectional shape taken along line A1-A2 in FIG. 6. Additional portions of the second insulation layer 330 are further removed to form the recesses 510PD and 510GD. Each of the recesses 510PD and 510GD has a groove shape that does not penetrate the second insulation layer 330 in the third direction D3 or a trench shape that does not penetrate the second insulation layer 330 in the third direction D3.

In an embodiment, some portions of the second insulation layer 330 are further removed to form the first recesses 510PD overlapping (for example, expanding a portion of or around) the first holes 510P in the second insulation layer 330. Each of the first recesses 510PD is formed in a line shape in which a portion overlaps the first hole 510P and another portion extends outward from the first hole 510P outside the first hole 510P. The first recesses 510PD extend in the first direction D1, the second direction D2, or a direction between the first direction D1 and the second direction D2. In an embodiment, a portion of the second insulation layer 330 is additionally removed to form the second recess 510GD overlapping the trench 510G in the second insulation layer 330. The second recess 510PG may be an upper trench that extends to overlap the lower trench 510G. In another embodiment, formation of the second recess 510GD may be omitted.

The first recesses 510PD and the second recess 510GD may be formed simultaneously. The first recesses 510PD and the second recesses 510GD may be formed by one and the same second patterning process. In an embodiment, a second etch mask (not shown) is formed on the second insulation layer 330 using a second photolithography process, and some portions of the second insulation layer 330 exposed by the second etch mask are etched to form the first recesses 510PD and the second recess 510GD. The second etch mask may include a second photoresist pattern or may further include a second hard mask having a pattern shape substantially the same as that of the second photoresist pattern.

Before etching the second insulation layer 330 to form the first recesses 510PD and the second recess 510GD, a sacrificial layer (not shown) may be further formed to fill the first holes 510P, the trench 510G, and the second holes 510C. The sacrificial layer protects the first holes 510P, the trench 510G, and the second holes 510C from the process of etching the second insulation layer 330 to form the first recesses 510PD and the second recess 510GD. The sacrificial layer may suppress or reduce undesirable damage to the first holes 510P, the trench 510G, and the second holes 510C during the process of etching the second insulation layer 330 to form the first recesses 510PD and the second recess 510GD. After forming the first recesses 510PD and the second recess 510GD, the sacrificial layer is removed. The sacrificial layer may include a different dielectric material from the second insulation layer 330. The sacrificial layer may include carbon, such as a spin on carbon (SoC) layer.

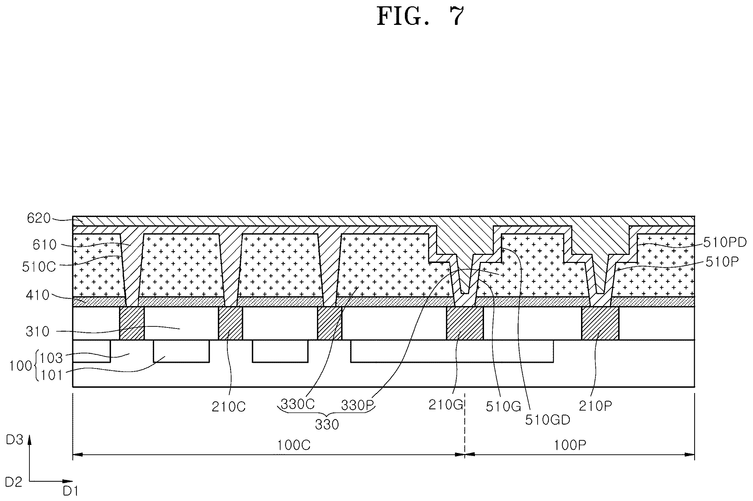

FIG. 7 illustrates a schematic cross-sectional structure in which conductive layers 610 and 620 are formed on the second insulation layer 330. A conductive material is deposited on the second insulation layer 330 to form the conductive layers 610 and 620. In an embodiment, the first conductive layer 610 is formed on the second insulation layer 330. The first conductive layer 610 is formed to fill the second holes 510C and extend into the first recesses 510PD and the first holes 510P. The first conductive layer 610 is formed to extend into the second recess 510GD and the trench 510G. In an embodiment, a width of the first recess 510PD and a diameter of the first hole 510P are wider than a diameter of the first hole 510C. Accordingly, the first conductive layer 610 may not completely fill the first recesses 510PD and the first holes 510P. The second conductive layer 620 is further formed on the first conductive layer 610 to fill the first recesses 510PD and the first holes 510P substantially and completely. In an embodiment, the widths of the second recess 510GD and the trench 510G are wider than the diameter of the first hole 510C. The second conductive layer 620 may extend to substantially completely fill the second recess 510GD and the trench 510G. Because the second holes 510C are filled with the first conductive layer 610, the second conductive layer 620 does not extend into the second holes 510C.

The second conductive layer 620 may include a different conductive material from the first conductive layer 610. The first conductive layer 610 includes titanium nitride (TiN). The second conductive layer 620 may include tungsten (W). The first conductive layer 610 includes a barrier metal layer for the second conductive layer 620. The barrier metal layer (of the first conductive layer 610) may suppress the conductive material of the second conductive layer 620 from undesirably diffusing or contaminating the surroundings. The first conductive layer 610 may include any of titanium nitride (TiN), tungsten nitride (WN), titanium tungsten nitride (TiWN), tungsten silicon nitride (WSiN), or a composite layer thereof.

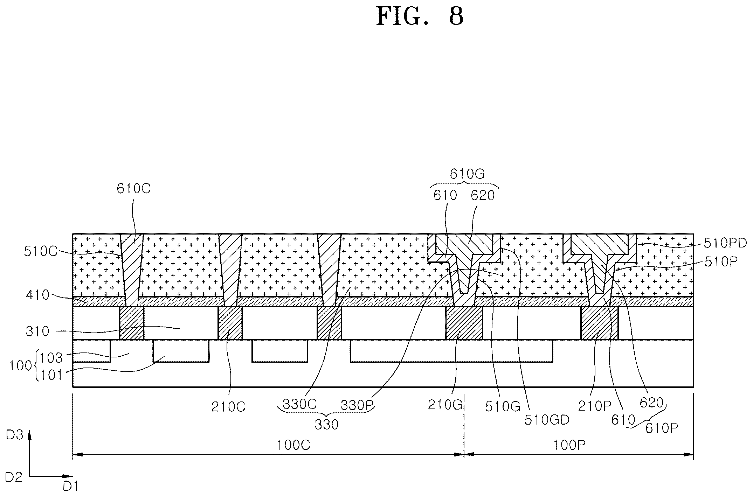

FIG. 8 illustrates a schematic cross-sectional structure in which the first conductive layer 610 and the second conductive layer 620 are (jointly) separated into a first conductive pattern 610P, a fifth conductive pattern 610G, and second conductive patterns 610C. The terms of the "first conductive pattern," the "second conductive pattern," and the "fifth conductive pattern" are for distinction from "third conductive pattern" and "fourth conductive pattern" to be described later, and do not indicate a specific order. Some portions of the first conductive layer 610 and the second conductive layer 620 are removed to expose a surface of the underlying second insulation layer 330. Some portions of the second conductive layer 620 are removed, and some portions of the first conductive layer 610 exposed when the portions of the second conductive layer 620 are removed are further removed. The first conductive layer 610 and the second conductive layer 620 may be subjected to chemical mechanical polishing (CMP) to expose the surface of the underlying second insulation layer 330. Accordingly, the first conductive pattern 610P, the fifth conductive pattern 610G, and the second conductive patterns 610C are separated from the first conductive layer 610 and the second conductive layer 620.

The first conductive pattern 610P may be separated into interconnections filling the first recesses 510PD and the first holes 510P. The interconnections may include via portions filling the first holes 510P and wiring portions filling the first recesses 510PD. The via portions are indicated as conductive contacts or conductive plugs. Because the via portions are electrically connected to the active regions 103 of the substrate 100, the interconnections are electrically connected to the substrate 100.

The first conductive patterns 610P are formed by processes of forming the first holes 510P in the second insulation layer 330, forming the first recesses 510PD, and then forming the conductive layers 610 and 620 filling the first recesses 510PD and the first holes 510P. In this manner, the first conductive patterns 610P may be formed by applying a dual damascene process.

The second conductive patterns 610C may include first storage nodes that fill the second holes 510C from the first conductive layer 610. In order to improve the performance of the semiconductor device, an embodiment may be designed with an increased height of the storage node of a capacitor to increase capacitance of the capacitor. In order to increase the height of the storage node of the capacitor, the storage node of the capacitor may be configured in a multi-stage structure. The first storage node may be a portion of the multi-stage structure. In an embodiment, the second conductive patterns 610C may have pillar shapes that fill the second holes 510C.

The fifth conductive pattern 610G includes a protection guard that fills the second recess 510GD and the trench 510G. As shown in FIG. 4, because the trench 510G divides the second insulation layer 330 into the first portion 330P and the second portion 330C, the protection guard divides the second insulation layer 330 into the first portion 330P and the second portion 330C.

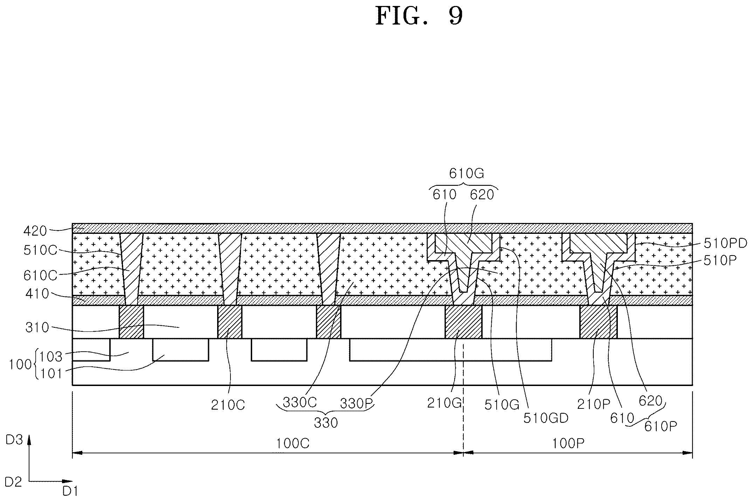

FIG. 9 illustrates a schematic cross-sectional structure in which a binding layer 420 covering the second insulation layer 330 is formed. The first binding layer 420 is formed to cover the second insulation layer 330, the first conductive patterns 610P, and the second conductive patterns 610C. The first binding layer 420 further extends to cover the fifth conductive pattern 610G. The first binding layer 420 protects the second insulation layer 330 and covers and insulates the first conductive patterns 610P, the second conductive patterns 610C, and the fifth conductive pattern 610G.

The first binding layer 420 includes a different dielectric material or different insulating material from the second insulation layer 330. In an embodiment, the first binding layer 420 includes silicon nitride such as trisilicon tetranitride (Si₃N₄). The first binding layer 420 may be formed to have a thinner thickness than the second insulation layer 330. The first binding layer 420 may indicate a nitride floating capacitor (NFC) structure.

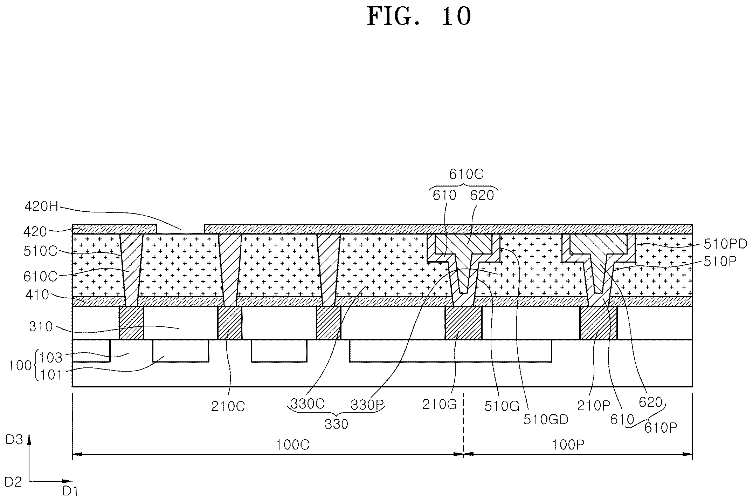

FIG. 10 illustrates a schematic cross-sectional structure in which a first opening 420H is formed in the first binding layer 420. A portion of the first binding layer 420 is removed to form the first opening 420H that substantially penetrates the first binding layer 420. A portion of the second portion 330C of the second insulation layer 330 is exposed to the first opening 420H. The first opening 420H is formed to be positioned not on the first portion 330P of the second insulation layer 330, but on the second portion 330C of the second insulation layer 330. The first opening 420H is formed at a position closer to the second conductive patterns 610C than to the first conductive patterns 610P. The first opening 420H is positioned to overlap a portion of the second portion 330C of the second insulation layer 330 between the second conductive patterns 610C.

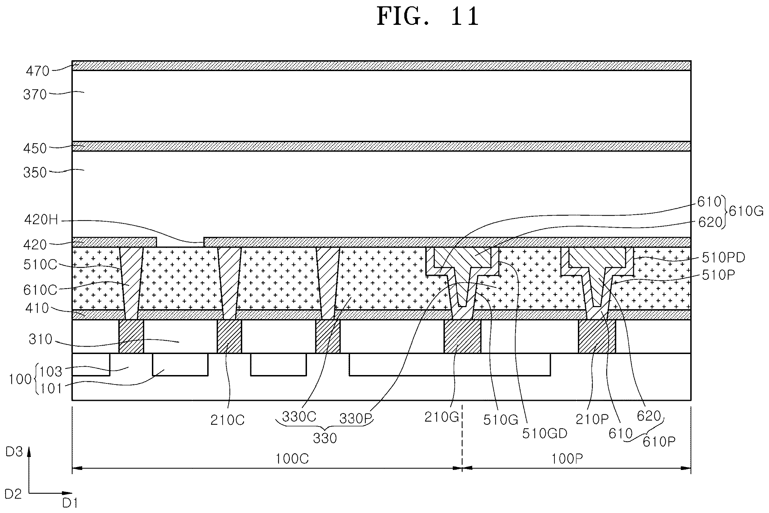

FIG. 11 illustrates a schematic cross-sectional structure in which mold layers 350 and 370 are formed on the first binding layer 420. A sacrificial layer is formed as the mold layers 350 and 370 on the first binding layer 420. Each of the mold layers 350 and 370 includes a different dielectric material or a different insulating material from the first binding layer 420. In an embodiment, each of the mold layers 350 and 370 includes a borophosphosilicate glass (BPSG) layer, a tetraethyl orthosilicate (TEOS) layer, an amorphous carbon layer, or a composite layer thereof. Each of the mold layers 350 and 370 also includes an oxide-nitride (ON) layer in which silicon oxide layers and silicon nitride layers are alternately repeated.

In an embodiment, the mold layers 350 and 370 may be formed in a multilayer structure including a first mold layer 350 at a bottom and a second mold layer 370 at a top. A second binding layer 450 may be further formed between the first mold layer 350 and the second mold layer 370. After forming the first mold layer 350 and forming the second binding layer 450 covering the first mold layer 350, the second mold layer 370 may be formed to cover the second binding layer 450. By forming the mold layers 350 and 370 in multiple layers in this manner, an overall thickness of the mold layers 350 and 370 can be increased. A third binding layer 470 covering the second mold layer 370 may be further formed. Each of the second binding layer 450 and the third binding layer 470 may include a different dielectric material or a different insulating material from the mold layers 350 and 370. The second binding layer 450 and the third binding layer 470 are formed in a thinner thickness than the first mold layer 350 and the second mold layer 370. In an embodiment, the second binding layer 450 and the third binding layer 470 include silicon nitride.

The mold layers 350 and 370 are connected to the second insulation layer 330 below through the first opening 420H of the first binding layer 420. Because the first mold layer 350 fills the first opening 420H of the first binding layer 420, the first mold layer 350 is connected to the second portion 330C of the second insulation layer 330 exposed in the first opening 420H.

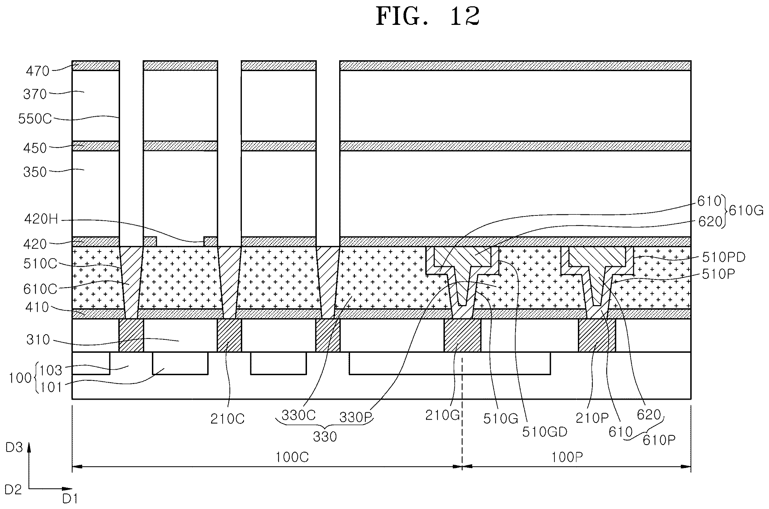

FIG. 12 illustrates a schematic cross-sectional structure in which third holes 550C penetrating the mold layers 350 and 370 are formed. Some portions of the mold layers 350 and 370 and the binding layers 420, 450, and 470 are removed to form the third holes 550C that substantially penetrate the mold layers 350 and 370 and the binding layers 420, 450, and 470. The plurality of third holes 550C are formed on the second portion 330C of the second insulation layer 330. The plurality of third holes 550C are formed over the second region 100C of the substrate 100. The third holes 550C are formed to expose some portions of the second conductive patterns 610C.

In an embodiment, although not shown, a third etch mask may be formed on the third binding layer 470 using a third photolithography process, and some portions of the third binding layer 470 exposed by the third etch mask may be etched and removed. The third etch mask may include a third photoresist pattern or may further include a third hard mask having a pattern shape substantially the same as the third photoresist pattern. Some portions of the second mold layer 370 exposed by removing some portions of the third binding layer 470 may be sequentially removed, and some portions of the second binding layer 450 exposed by removing some portions of the second mold layer 370 may be sequentially removed. Some portions of the first mold layer 350 exposed by removing some portions of the second binding layer 450 may be further removed, and some portions of the first binding layer 420 exposed by removing some portions of the first mold layer 350 may be removed, thereby forming the third holes 550C.

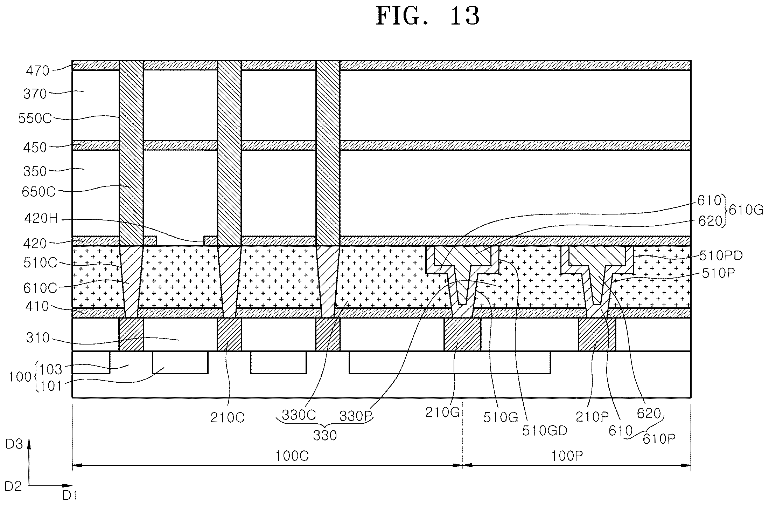

FIG. 13 illustrates a schematic cross-sectional structure in which third conductive patterns 650C connected to the second conductive patterns 610C are formed. A third conductive layer is formed on the third binding layer 470 to extend to cover the third holes 550C. Some portions of the third conductive layer are removed to separate the third conductive patterns 650C filling the third holes 550C from the third conductive layer. The third conductive patterns 650C may be second storage nodes connected to the second conductive patterns 610C, which are the first storage nodes. Each of the second conductive patterns 610C and each of the third conductive patterns 650C may be stacked to form a storage node of a capacitor.

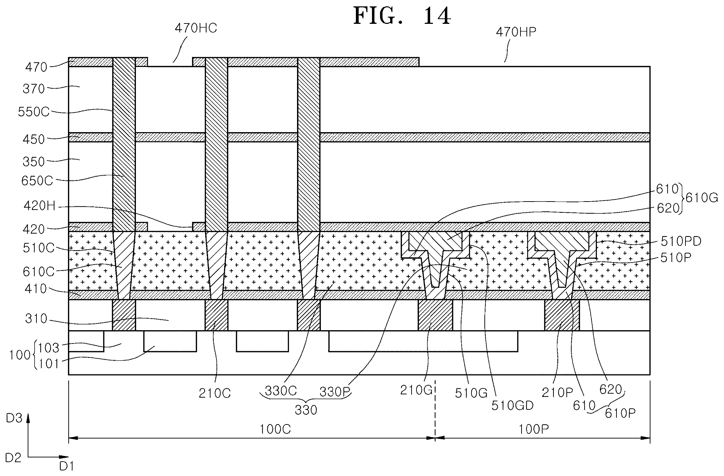

FIG. 14 illustrates a schematic cross-sectional structure in which a second opening 470HC and a third opening 470HP are formed in the third binding layer 470. Additional portions of the third binding layer 470 may be further removed to form the second opening 470HC and the third opening 470HP that substantially penetrate the third binding layer 470. The second opening 470HC and the third opening 470HP expose the portions of the second mold layer 370 located under the third binding layer 470. The second opening 470HC may be positioned over the second portion 330C of the second insulation layer 330, and the third opening 470HP may be positioned over the first portion 330P of the second insulation layer 330. The second opening 470HC may be positioned over the second region 100C of the substrate 100, and the third opening 470HP may be positioned over the first region 100P of the substrate 100.

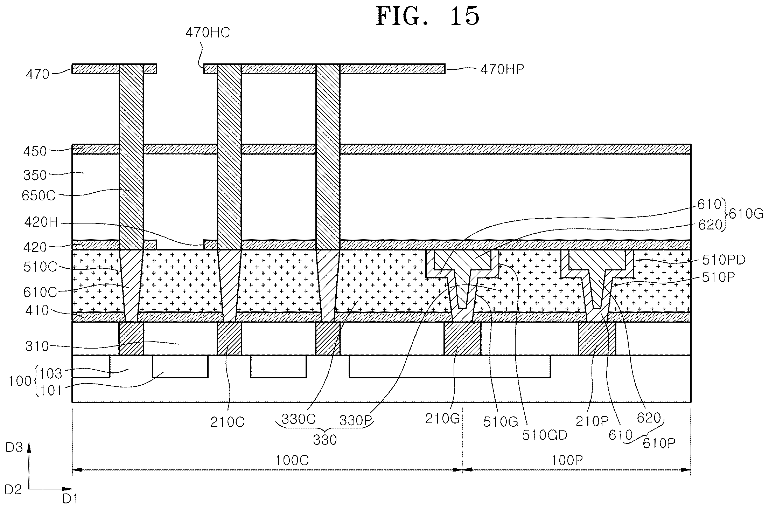

FIG. 15 illustrates a schematic cross-sectional structure in which the second mold layer 370 in FIG. 14 is removed. Referring to FIG. 14 and FIG. 15, the second mold layer 370 under the third binding layer 470 is removed through the second opening 470HC and the third opening 470HP of the third binding layer 470. An etchant is introduced into the second mold layer 370 through the second opening 470HC and the third opening 470HP of the third binding layer 470, and thus, the second mold layer 370 is removed by the introduced etchant.

Remaining portions of the third binding layer 470 are connected to the third conductive patterns 650C to bind the third conductive patterns 650C to each other. Because the third conductive patterns 650C are bound together by the third binding layer 470, the third conductive patterns 650C can be supported by the third binding layer 470 without collapsing.

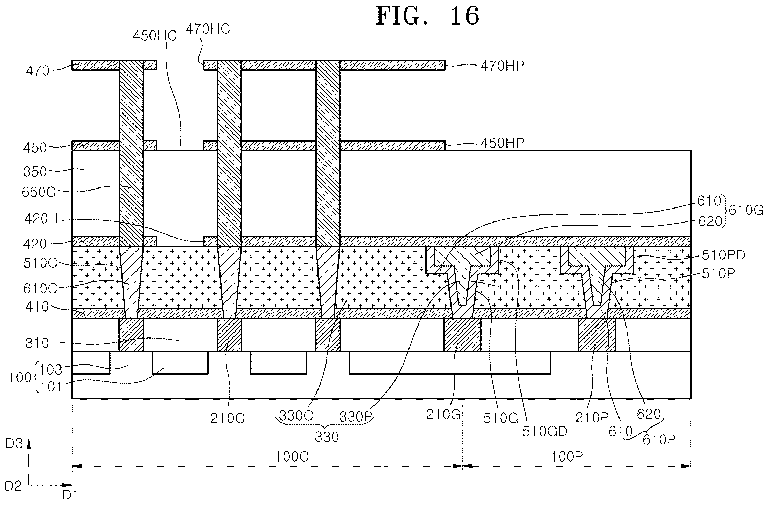

FIG. 16 illustrates a schematic cross-sectional structure in which a fourth opening 450HC and a fifth opening 450HP are formed in the second binding layer 450. After the second mold layer 370 is removed, some portions of the second binding layer 450 exposed by removing the second mold layer 370 are further removed. As some portions of the second binding layer 450 are removed, the fourth opening 450HC and the fifth opening 450HP that substantially penetrate the second binding layer 450 are formed. Some portions of the second binding layer 450 exposed to the remaining third binding layer 470 and the third conductive patterns 650C are etched away. This etching process may be performed by an anisotropic etching process using the remaining third binding layer 470 and the third conductive patterns 650C as etch masks. The fourth opening 450HC of the second binding layer 450 may be aligned to overlap the second opening 470HC of the third binding layer 470 in the third direction D3. The fifth opening 450HP of the second binding layer 450 may be aligned to overlap the third opening 470HP of the third binding layer 470 in the third direction D3.

The fourth opening 450HC and the fifth opening 450HP may expose some portions of the first mold layer 350 located under the second binding layer 450. The fourth opening 450HC may be positioned over the second portion 330C of the second insulation layer 330, and the fifth opening 450HP may be positioned over the first portion 330P of the second insulation layer 330. The fourth opening 450HC is positioned over the second region 100C of the substrate 100, and the fifth opening 450HP is positioned over the first region 100P of the substrate 100.

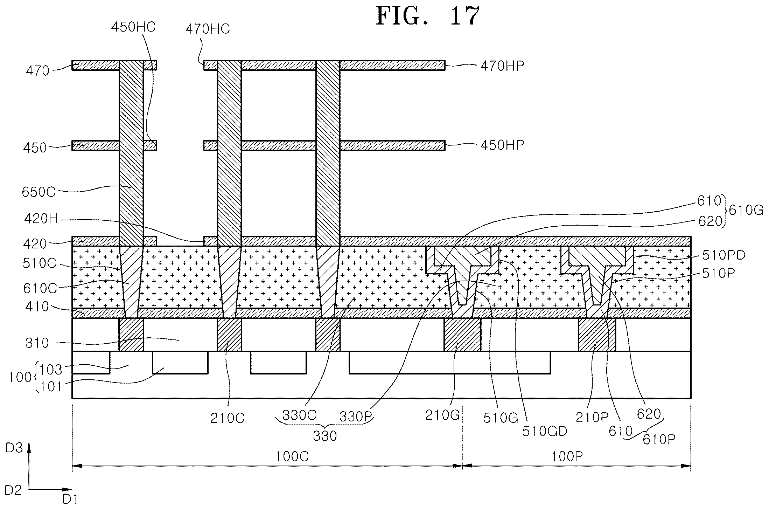

FIG. 17 illustrates a schematic cross-sectional structure in which the first mold layer 350 in FIG. 16 is removed. Referring to FIG. 16 and FIG. 17, the first mold layer 350 under the second binding layer 450 is removed. An etchant is introduced into the first mold layer 350 through the fourth opening 450HC and the fifth opening 450HP of the second binding layer 450, so that the first mold layer 350 is removed by the introduced etchant. By removing the first mold layer 350 in this manner, the first opening 420H of the first binding layer 420 is exposed. A portion of the second portion 330C of the underlying second insulation layer 330 may be exposed to the first opening 420H of the first binding layer 420.

Remaining portions of the second binding layer 450 are connected to the third conductive patterns 650C to bind the third conductive patterns 650C. Because the third conductive patterns 650C are bound together by the second binding layer 450, the third conductive patterns 650C can be supported by the second binding layer 450 without collapsing.

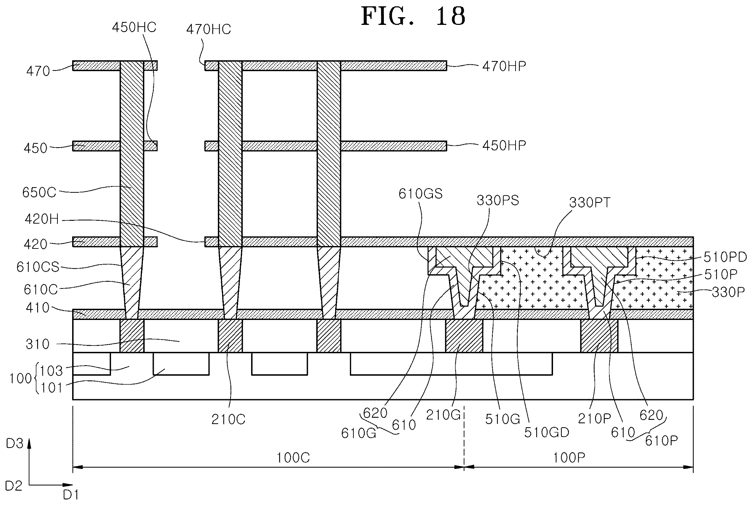

FIG. 18 illustrates a schematic cross-sectional structure in which the second portion 330C in FIG. 17 of the second insulation layer 330 in FIG. 17 is removed. Referring to FIG. 17 and FIG. 18, the second portion 330C, which is a portion of the second insulation layer 330 under the first binding layer 420, is removed through the first opening 420H of the first binding layer 420. An etchant is introduced into the second portion 330C of the second insulation layer 330 through the first opening 420HC of the first binding layer 420, so that the second portion 330C of the second insulation layer 330 is removed by the introduced etchant.

In this manner, by removing the second portion 330C of the second insulation layer 330, first side surfaces 610CS of the second conductive patterns 610C are exposed. Because the fifth conductive pattern 610G is a protection guard that protects the first portion 330P of the second insulation layer 330, the etchant can be prevented from flowing into the first portion 330P of the second insulation layer 330. The fifth conductive pattern 610G covers a second side surface 330PS of the first portion 330P of the second insulation layer 330 and extends to be connected to the first binding layer 420, and the first binding layer 420 covers and protects an upper surface 330PT of the first portion 330P of the second insulation layer 330, so that the first portion 330P of the second insulation layer 330 can be protected from the etchant. Because the etchant can be blocked from flowing into the first portion 330P of the second insulation layer 330 by the first binding layer 420 and the fifth conductive pattern 610G, the first portion 330P of the second insulation layer 330 can be protected from the process of removing the second portion 330C of the second insulation layer 330. Even though the second portion 330C of the second insulation layer 330 is removed, the first portion 330P of the second insulation layer 330 remains to surround and insulate the first conductive pattern 610P. A third side surface 610GS, which is a side surface of the fifth conductive pattern 610G, is exposed when the second portion 330C of the second insulation layer 330 is removed.

The remaining portions of the first binding layer 420 may be connected to the third conductive patterns 650C to bind the third conductive patterns 650C. Because the third conductive patterns 650C are bound together by the first binding layer 420, the third conductive patterns 650C can be supported by the first binding layer 420 without collapsing.

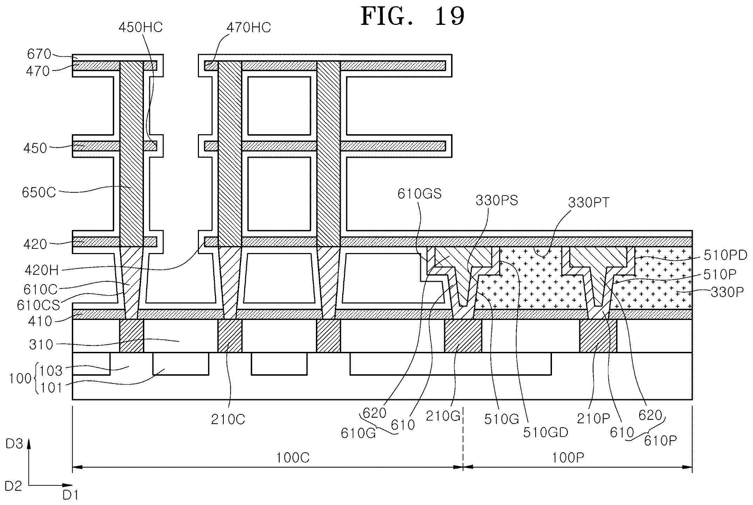

FIG. 19 illustrates a schematic cross-sectional structure in which a dielectric layer 670 is formed. The dielectric layer 670 is formed that covers the first side surfaces 610CS of the first conductive patterns 610C and extends through the first opening 420H of the first binding layer 420 to cover the third conductive patterns 650C. The dielectric layer 670 extends to cover the exposed surfaces of the first binding layer 420, the second binding layer 450, and the third binding layer 470. The dielectric layer 670 further extends to cover the exposed third side surface 610GS of the fifth conductive pattern 610G.

The dielectric layer 670 may be a dielectric layer of a capacitor. The dielectric layer 670 may include a high-k dielectric material layer having a high dielectric constant (k). The dielectric layer 670 includes zirconium oxide (ZrO₂), aluminum oxide (Al₂O₃), or tantalum oxide (Ta₂O₅).

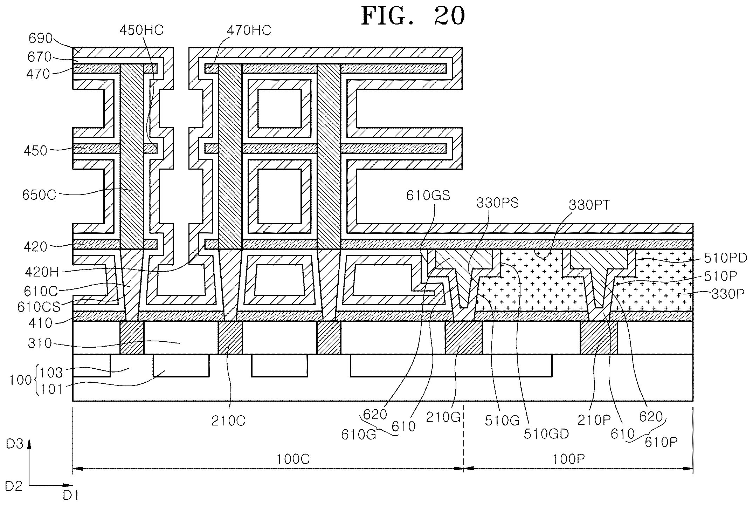

FIG. 20 illustrates a schematic cross-sectional structure in which a fourth conductive pattern 690 covering the dielectric layer 670 is formed. The fourth conductive pattern 690 extends to cover the dielectric layer 670. The fourth conductive pattern 690 may include a plate node of a capacitor. The fourth conductive pattern 690 includes a layer of various electrode materials. The fourth conductive pattern 690 may include a metal layer or a metal nitride layer such as titanium nitride (TiN). A capacitor structure can be formed, which includes a storage node including the second conductive patterns 610C and the third conductive pattern 650C, the dielectric layer 670, and a plate node including the fourth conductive pattern 690.

In the method of fabricating a semiconductor device according to an embodiment of the present disclosure, a second insulation layer 330 is formed on a substrate 100 as shown in FIG. 2, and a first hole 510P and second holes 510C penetrating the second insulation layer 330 are formed as shown in FIG. 3. As shown in FIG. 5 and FIG. 6, a first recess 510PD is formed overlapping the first hole 510P. As shown in FIG. 7 and FIG. 8, a first conductive pattern 610P filling the first hole 510P and the first recess 510PD is formed simultaneously with second conductive patterns 610C filling the second holes 510C. Third conductive patterns 550C as shown in FIG. 13 are formed to be connected to the second conductive patterns 610C.

In the method of fabricating the semiconductor device according to an embodiment of the present disclosure, a second insulation layer 330 is formed on a substrate 100 as shown in FIG. 2, and a first hole 510P, a trench 510G, and second holes 510C penetrating the second insulation layer 330 are simultaneously formed as shown in FIG. 3. The trench 510G divides the second insulation layer 330 into a first portion 330P and a second portion 330C. As shown in FIG. 7 and FIG. 8, a first conductive pattern 610P filling at least the first hole 510P, a fifth conductive pattern 610G filling at least the trench 510G, and second conductive patterns 610C filling the second holes 510C may be formed simultaneously. The third conductive patterns 550C as shown in FIG. 13 may be formed to be connected to the second conductive patterns 610C. As shown in FIG. 17 and FIG. 18, the second portion 330C of the second insulation layer 330 is removed to expose first side surfaces 610CS of the second conductive patterns 610C.

A semiconductor device according to an embodiment of the present disclosure includes a substrate 100 including a first region 100P and a second region 100C as shown in FIG. 20, and includes a second portion 330P of a second insulation layer formed on the first region 100P of the substrate 100. The semiconductor device includes a first conductive pattern 610P penetrating a second portion 330P of a second insulation layer and second conductive patterns 610C formed on a second region 100C of the substrate 100. The semiconductor device further includes third conductive patterns 650C connected to the second conductive patterns 610C. The semiconductor device includes a first binding layer 420 that covers the first conductive pattern 610P and a top surface 330PT of the second portion 330P of the second insulation layer. The first binding layer 420 is connected to the third conductive patterns 650C. The semiconductor device further includes a fifth conductive pattern 610G that covers a second side surface 330PS of the second portion 330P of the second insulation layer and extends in a third direction D3 to be connected to the first binding layer 420.

Concepts are disclosed in conjunction with various examples and embodiments. Those skilled in the art will understand that various modifications, additions, and substitutions are possible without departing from the scope and technical concepts of the present disclosure. The embodiments disclosed in the present specification should be considered from an illustrative standpoint and not considered from a restrictive standpoint. The scope of the present disclosure is not limited to the descriptions, and all distinctive features within an equivalent scope should be construed as included in the present disclosure. All changes within the meaning and range of equivalency of the claims are included within their scope.

## Claims

1. A method of fabricating a semiconductor device, the method comprising:
forming an insulation layer over a substrate;
forming a first hole and a second hole that penetrate the insulation layer;
forming a recess in the insulation layer overlapping the first hole;
forming a first conductive pattern that fills the first hole and the recess and a second conductive pattern that fills the second hole; and
forming a third conductive pattern connected to the second conductive pattern.

2. The method of claim 1,
wherein the first conductive pattern comprises an interconnection connected to the substrate; and
wherein the second conductive pattern and the third conductive pattern form a storage node of a capacitor.

3. The method of claim **1,** further comprising:
removing, after forming the third conductive pattern, a portion of the insulation layer to expose a first side surface of the second conductive pattern;
forming a dielectric layer that covers the first side surface of the second conductive pattern and extends to cover the third conductive pattern; and
forming a fourth conductive pattern that covers the dielectric layer.

4. The method of claim 3, further comprising, before forming the third conductive pattern:
forming a binding layer that covers the insulation layer, the first conductive pattern, and the second conductive pattern; and
forming an opening that penetrates the binding layer at a position closer to the second conductive pattern than the first conductive pattern,
wherein the portion of the insulation layer is removed through the opening.

5. The method of claim 4, wherein the dielectric layer and the fourth conductive pattern extend to pass through the opening.

6. The method of claim 3, wherein other portions of the insulation layer are remained to surround the first conductive pattern.

7. The method of claim **1,** wherein forming the first conductive pattern and the second conductive pattern comprises:
forming a first conductive layer that fills the second hole and extends into the first hole and the recess;
forming a second conductive layer that fills the first hole and the recess; and
removing a portion of the second conductive layer and a portion of the first conductive layer to separate the first conductive pattern and the second conductive pattern from the first conductive layer and the second conductive layer, respectively.

8. The method of claim 1, further comprising forming a first contact that connects the first conductive pattern to the substrate and a second contact that connects the second conductive pattern to the substrate.

9. A method of fabricating a semiconductor device, the method comprising:
forming an insulation layer over a substrate;
forming a first hole, a trench, and a second hole to penetrate the insulation layer, the trench dividing the insulation layer into a first portion and a second portion;
forming a first conductive pattern that fills the first hole, a fifth conductive pattern that fills the trench, and a second conductive pattern that fills the second hole;
forming a third conductive pattern connected to the second conductive pattern; and
removing the second portion of the insulation layer to expose a first side surface of the second conductive pattern.

10. The method of claim 9,
further comprising forming a first recess in the insulation layer that overlaps the first hole and a second recess in the insulation layer that overlaps the trench,
wherein the fifth conductive pattern extends to fill the second recess; and
wherein the first conductive pattern extends to fill the first recess.

11. The method of claim 10, wherein forming the first conductive pattern and the second conductive pattern comprises:
forming a first conductive layer on the insulation layer, the first conductive layer filling the second hole, extending into the second recess and the trench, and extending into the first recess and the first hole;
forming a second conductive layer on the first conductive layer, the second conductive layer filling the second recess and the trench and the first recess and the first hole; and
removing a portion of the second conductive layer and a portion of the first conductive layer to separate the first conductive pattern, the fifth conductive pattern, and the second conductive pattern from the first conductive layer and the second conductive layer.

12. The method of claim 9, further comprising, before forming the third conductive pattern:
forming a binding layer that covers the insulation layer, the first conductive pattern, the fifth conductive pattern, and the second conductive pattern; and
forming an opening that penetrates the binding layer at a position closer to the second conductive pattern than the first conductive pattern,
wherein the second portion of the insulation layer is removed through the opening.

13. The method of claim 12, further comprising:
forming a dielectric layer that covers the first side surface of the second conductive pattern and extends to cover the third conductive pattern through the opening; and
forming a fourth conductive pattern that covers the dielectric layer.

14. A semiconductor device comprising:
an insulation layer disposed over a first region of a substrate, which includes the first region and a second region;
a first conductive pattern that penetrates the insulation layer;
a second conductive pattern formed over the second region;
a third conductive pattern connected to the second conductive pattern; and
a binding layer covering the first conductive pattern and the insulation layer and connected to the third conductive pattern.

15. The semiconductor device of claim 14,
wherein the binding layer is connected to the third conductive pattern,
further comprising an opening that penetrates the binding layer.
